**Europäisches Patentamt**

**European Patent Office**

**Office européen des brevets**

(19)

(11) Veröffentlichungsnummer: **0 136 630**

**A2**

(12) ## EUROPÄISCHE PATENTANMELDUNG

(21) Anmeldenummer: **84111254.3**

(22) Anmeldetag: **20.09.84**

(51) Int. Cl.⁴: **H 01 H 13/70**

(30) Priorität: **03.10.83 US 538441**

(43) Veröffentlichungstag der Anmeldung:
**10.04.85 Patentblatt 85/15**

(84) Benannte Vertragsstaaten:
**AT CH DE FR GB IT LI NL SE**

(71) Anmelder: **Siemens Aktiengesellschaft
Berlin und München Wittelsbacherplatz 2
D-8000 München 2(DE)**

(72) Erfinder: **Tsikos, Constantine J.
5316 King Avenue
Pennsauken New Jersey 08109(US)**

(54) **Alphanumerisches Tastenfeld.**

(57) Ein einfaches, kostengünstiges alphanumerisches Tastenfeld enthält in der Reihenfolge von dessen Unterseite bis zu dessen Oberseite (a) eine Basis, die eine nichtleitende, nach oben weisende Stützfläche (24), (b) einen leitenden Streifen (26), der auf der Stützfläche (24) angeordnet ist, und (c) eine flexible Lage (56) die oberhalb des leitenden Streifens (26) angeordnet ist. Der leitende Streifen (26) ist vorzugsweise als ein fortlaufender Streifen aus einem mit einem elektrischen Widerstand behafteten Material gebildet, das einen im wesentlichen gleichförmigen, konstanten Widerstand je Längeneinheit aufweist. Die flexible Lage (56), die oberhalb des leitenden Streifens (26) angeordnet ist, hat eine leitende Oberfläche, die nach unten in Richtung des lietenden Streifens (26) weist. Die flexible Lage (56) ist in einer Weise befestigt, daß sie normalerweise außer Kontakt mit dem leitenden Streifen (26) steht, jedoch manuell in Richtung auf den leitenden Streifen (26) niedergedrückt werden kann, um in Kontakt mit dem leitenden Streifen (26) an individuellen Stellen zu kommen, die den betreffenden alphanumerischen Zeichen (18) zugeordnet sind. Der leitende Streifen (26) und die flexible Lage (56) bilden auf diese Weise einen Spannungsteiler, der eine bestimmte Spannung in Abhängigkeit von dem Punkt des Kontakts zwischen dem leitenden Streifen (26) und der flexiblen Lage (56) erzeugt. Diese Spannung wird an einem A/D-Wandler (34) gelegt, der ein digitales Signal bildet.

FIG. 2

## Alphanumerisches Tastenfeld

Die vorliegende Erfindung bezieht sich auf Tastenfeld des
Typs, der eine Vielzahl von Tasten hat, die jeweils einem
bestimmten        alphanumerischen Zeichen zugeordnet sind.
Insbesondere bezieht sich die Erfindung auf ein besonders
kostengünstiges Tastenfeld, das mit einer Mindestanzahl von
mechanischen und elektrischen Teilen aufgebaut ist.

Es ist bekannt, Tastenfelder herzustellen, die das Prinzip
eines Spannungsteilers verwenden. Beispielsweise ist in der
DAS 2 654 970 und der DOS 2 651 029 eine Anordnung für Drucktasten-Sensoren offenbart, die aus einer Vielzahl von Widerständen besteht, welche in Reihe angeordnet sind, um einen
langen Spannungsteiler zu bilden. Tasten oder Drucktasten
sind mit Anschlüssen zwischen jeweils aufeinanderfolgenden
Widerständen auf einer Seite und mit einem Analog-Digital-
Wandler auf deren anderen Seite verbunden. Wenn eine Taste
niedergedrückt wird, schließt sie einen Stromkreis zwischen
einem der Anschlüsse in dem Spannungsteiler und dem Analog-
Digital-Wandler. Die Spannung an diesem Punkt an dem Spannungsteiler wird dann in eine digital dargestellte Zahl umgewandelt, die die Drucktaste identifiziert, welche niedergedrückt wurde.

Obgleich das Spannungsteiler-Prinzip bekannt und in Verbindung mit Tastenfeldern für eine geraume Zeit benutzt worden
ist, ist der Vorteil eines solchen Systems nicht vollständig
erkannt worden. Insbesondere ist die Möglichkeit der Verwendung dieses Prinzips zum Herstellen von Tastenfeldern
mit extrem niedrigen Kosten nicht ausgeschöpft worden.

Der vorliegenden Erfindung liegt die Aufgabe zugrunde, ein
alphanumerisches Tastenfeld zu schaffen, das besonders einfach und kostengünstig herzustellen ist. Diese Aufgabe sowie weitere Aufgaben, die aus der im folgenden gegebenen Beschreibung ersichtlich werden, werden gemäß der vorliegenden Erfindung durch Vorsehen folgender Elemente in ihrer Reihenfolge von der Unterseite bis zu der Oberseite gelöst:

(a) eine Basis, die eine nichtleitende, aufwärts gerichtete Stützfläche hat;

(b) einen leitenden Streifen, der auf der Stützfläche angeordnet ist;

(c) eine flexible Schicht, die oberhalb des leitenden Streifens angeordnet ist.

Der leitende Streifen kann entweder ein fortlaufender Streifen eines mit einem elektrischen Widerstand behafteten Materials sein, das einen im wesentlichen gleichförmigen, konstanten Widerstand je Längeneinheit aufweist, oder kann aus einer Folge von leitenden Kontaktplatten und einer Vielzahl von Widerständen gebildet sein, die zwischen die Kontaktplatten geschaltet sind. In jedem Fall bildet der leitende Streifen eine Vielzahl von nach oben gerichteten Kontaktflächen, die längs seiner Längsausdehnung in im wesentlichen gleichen Intervallen angeordnet sind, sowie einen elektrischen Widerstand zwischen jeweils aufeinanderfolgenden dieser Kontaktflächen.

Die flexible Schicht oder Lage, die oberhalb des leitenden Streifens angeordnet ist, hat eine leitende Oberfläche, die nach unten in Richtung des Streifens weist. Die Schicht oder Lage ist derart befestigt, daß sie normalerweise außer Kontakt mit dem Streifen ist, jedoch in der Lage ist, manuell in Richtung auf den Streifen an individuellen Punkten niedergedrückt zu werden, d.h.solchen Punkten, die unmittelbar oberhalb der Kontaktoberflächen liegen. Wenn sie derart an einem derartigen Punkt niedergedrückt wird, kommt die leitende Oberfläche der flexiblen Schicht oder Lage in Kontakt mit einer der Kontaktflächen des leitenden Streifens.

Es ist sowohl zumindest zu einem Ende des leitenden Streifens als auch zu der leitenden Oberfläche der flexiblen Schicht oder Lage eine elektrische Verbindung vorgesehen. Eine Spannungsquelle ist mit einer dieser beiden elektrischen Verbindungen verbunden, während die andere mit einem Analog-Digital-Wandler verbunden ist. Wenn ein Kontakt zwischen der leitenden Oberfläche der flexiblen Lage und der Kontaktoberfläche des leitenden Streifens hergestellt wird, fließt ein Strom, der durch die Position der ausgewählten Kontaktoberfläche im Spannungsteiler bestimmt ist, der durch den leitenden Streifen gebildet wird. Demzufolge bestimmt die Spannung, die durch den Analog-Digital-Wandler dargestellt wird, eindeutig die ausgewählte Kontaktfläche, und der Analog-Digital-Wandler bildet ein digitales Signal, das das alphanumerische Zeichen identifiziert, welches dieser Kontaktfläche zugeordnet ist. Falls dies gewünscht, kann dies digitale Signal in einen ASCII-Zeichencode mittels einer einfachen Umsetztabelle in einem Nur-Lesespeicher (ROM) umgesetzt werden.

Die zuvor genannte und weitere Aufgaben, Merkmale und Vorteile der vorliegenden Erfindung werden aus der im folgenden anhand mehrerer, bevorzugte Ausführungsbeispiele für die vorliegende Erfindung betreffender Figuren gegebenen Beschreibung ersichtlich.

Fig. 1 zeigt eine perspektivische Ansicht eines Tastenfeldes, das gemäß der vorliegenden Erfindung aufgebaut ist.

Fig. 2 zeigt eine Draufsicht- teilweise geöffnet- eines Tastenfeldes gemäß einem bevorzugten Ausführungsbeispiel für die vorliegende Erfindung.

Fig. 3 zeigt eine Schnittansicht längs einer Schnittlinie 3-3, die in Fig. 2 gezeigt ist.

Fig. 4 zeigt eine Schnittansicht eines Teils des Tastenfeldes, das in Fig. 3 gezeigt ist, und zwar in einem Maßstab 1:1.

Fig. 5 zeigt ein schematisches Prinzipschaltbild der elektrischen Schaltung, die in dem Tastenfeld gemäß den Figuren 1 bis 4 verwendet wird.

Fig. 6 zeigt eine schematische Ansicht eines Tastenfeldes gemäß einem weiteren bevorzugten Ausführungsbeispiel für die vorliegende Erfindung.

Fig. 7 zeigt eine schematische Schaltungsdarstellung eines alternativen Ausführungsbeispiels für den leitenden Streifen,der in dem Tastenfeld gemäß der vorliegenden Erfindung verwendet wird.

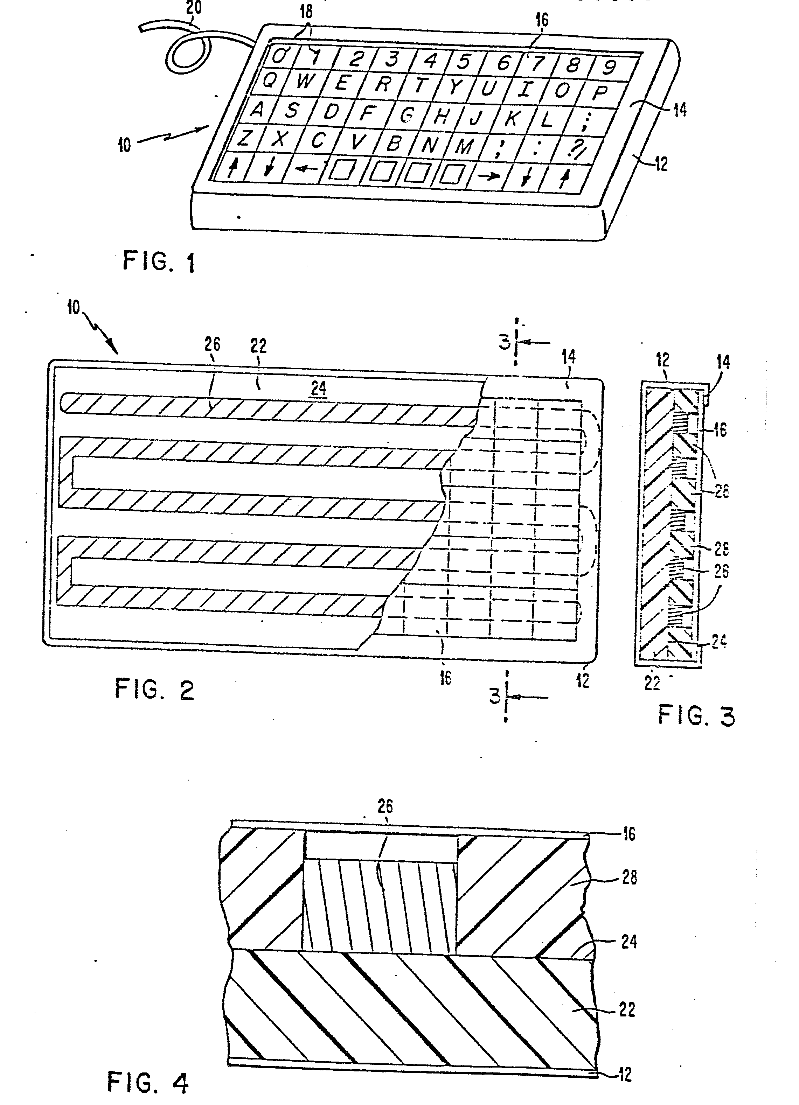

Die bevorzugten Ausführungsbeispiele für die vorliegende Erfindung werden nun anhand der Figuren 1 bis 7 beschrieben. Dabei sind identische Elemente in den verschiedenen Figuren mit gleichen Bezugszeichen bezeichnet.

Fig. 1 zeigt ein einzeln stehendes Tastenfeld 10 des Typs, der sich auf die vorliegende Erfindung bezieht. Dieses Tastenfeld enthält (1) eine Tastenfeldbasis oder ein Gehäuse 12, das einen oberen Rand 14 hat, der (2) dessen obere Fläche bildet, eine flexible Schicht oder Lage eines Materials 16, auf dem verschiedene alphanumerische Zeichen 18 bezeichnet (gedruckt) sind. Das Gehäuse 12 kann aus Metall oder Plastik hergestellt sein. Die Lage 16 besteht vorzugsweise aus einem aluminisierten Mylar. Das Tastenfeld kann mit einem CRT-Terminal, einem Computer oder einem Drucker mittels eines flexiblen elektrischen Kabels 20 verbunden sein.

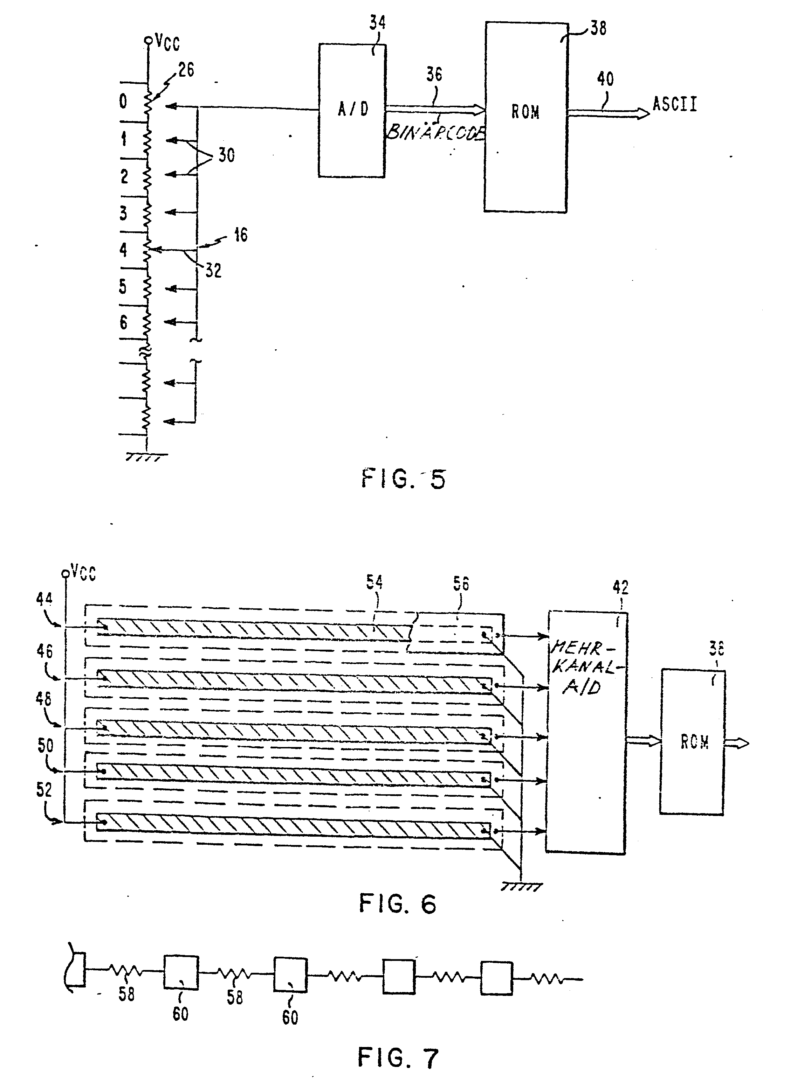

Innerhalb des Tastenfeldes 10 ist eine Konstruktion des Typs angeordnet, der entweder in den Figuren 2 bis 5 (ein Ausführungsbeispiel) oder der Figur 6 (ein weiteres Ausführungsbeispiel) gezeigt ist.

0136630

Das Ausführungsbeispiel gemäß den Figuren 2 bis 5 enthält eine Lage 22 aus einem isolierenden Material, welches auf der Innenfläche des Gehäuses 12 angeordnet ist, um eine Stützfläche 24 für die darauf befindliche Konstruktion zu bilden. Wenn das Gehäuse aus einem isolierenden Material hergestellt ist, ist die Lage 22 nicht unbedingt erforderlich. In einem derartigen Fall kann die Stützfläche 24 direkt durch das Gehäuse selbst gebildet sein.

Auf der Stützfläche 24 ist ein leitender Streifen 26, wie in Fig. 2 gezeigt, in einer serpentinenartigen Anordnung vorgesehen. Dieser leitende Streifen kann aus einem mit einem elektrischen Widerstand behafteten Material gebildet sein, so daß er einen im wesentlichen gleichförmigen, konstanten Widerstand je Längeneinheit aufweist. Die obere, freiliegende Fläche 28 des leitenden Streifens bildet Kontaktflächen für ggf. herzustellende mechanische Kontakte mittels eines elektrischen Leiters.

Unmittelbar oberhalb des leitenden Streifens 26 ist die bereits zuvor erwähnte flexible Lage 16 angeordnet, die entweder selbstleitend sein kann oder die eine leitende Schicht auf ihrer unteren Fläche aufweist. Diese Lage wird in einer Position gehalten, in der sie außer Berührung mit dem leitenden Streifen 26 ist, und zwar durch ein elastisches Material 28, das bei dem leitenden Streifen angeordnet ist und zwischen die flexible Lage 16 und die Stützfläche 24 eingebettet ist. Das elastische Material ist vorzugsweise nichtleitend (oder ist ansonsten von dem leitenden Steifen 26 isoliert) und in Spalten zwischen den verschiedenen geradlinigen Abschnitten des flexiblen Steifens angeordnet. Wenn dies gefordert wird, kann das elastische Material 28 sich außerdem oberhalb und quer zu dem leitenden Streifen 26 erstrecken, auf welche Weise ein Kreuz-und Quer-Muster gebildet wird, das individuelle Öffnungen für Kon-

takte zwischen der flexiblen Lage 16 und dem leitenden Streifen 16 aufweist.

Wie in Fig. 5 gezeigt, enthält das elektrische System eine Spannungsquelle $V_{CC}$, die an das eine Ende des leitenden Streifens 26 angeschlossen ist, der in der Figur als ein langgestreckter Widerstand dargestellt ist. Die flexible Lage 16 hat eine Vielzahl von Kontaktbereichen, die durch Pfeile 30 angedeutet sind. Einer dieser Pfeile, nämlich 32, ist so dargestellt, als befände er sich in Kontakt mit dem leitenden Streifen.

Im Grunde genommen stellt Fig. 5 ein Potentiometer dar, das in zwei Dimensionen(X und Y) aufgebaut ist, für das die flexible Lage 16 als "Schleifarm" dient. Durch Anlegen einer bekannten Spannung zwischen den beiden Enden des leitenden Streifens 26 und durch Berühren der Oberfläche des leitenden Streifens mit der flexiblen Lage in verschiedenen Bereichen werden unterschiedliche Spannungen gewonnen. Diese Spannungen werden dann mittels eines Analog/Digital-Wandlers 34 quantisiert, um ein digitales, binär codiertes Signal auf Ausgangsleitungen 36 zu erzeugen. Dieses Signal wird als eine Adresse an einen Nur-Lesespeicher (ROM) geliefert, der eine Umsetztabelle für ASCII-Codes für die alphanumerischen Zeichen enthält. Der jeweils betreffende ASCII-Code wird dann durch den ROM an dessen Datenausgangsleitungen 40 erzeugt.

Um die Auflösung zu verbessern und um mögliche Quantisierungsfehler zu eliminieren, kann ein Mehrkanal-Analog/Digital-Wandler 42 verwendet werden, um parallel Eingangssignale von getrennten 'Potentiometern' 44 ..52 aufzunehmen, wie dies in Fig. 6 gezeigt ist. Jedes dieser 'Potentiometer' besteht aus einem separaten leitenden Streifen 54 und einer zugeordneten flexiblen Lage 56, die sich unmittelbar darüber befindet. Der leitende Streifen 54 ist an seinem einen Ende mit einer Spannungsquelle $V_{CC}$ und an seinem gegenüberliegenden Ende mit Masse oder Erde verbunden. Die flexible Lage, die auch aus aluminisiertem Mylan bestehen kann, ist mit dem Mehrkanal-A/D-Wandler verbunden.

Fig. 7 zeigt ein alternatives Ausführungsbeispiel für einen leitenden Streifen. Anstelle des Vorsehens eines homogenen Stückes eines widerstandsbehafteten Materials kann der Streifen aus diskreten Widerständen 58 aufgebaut sein, die zwischen separate leitende Kontaktplatten 60 geschaltet sind, um eine Reihenschaltung zu bilden. Jede Kontaktplatte bildet auf diese Weise eine separate Fläche für eine mechanische Berührung und damit einen elektrischen Kontakt der flexiblen Lage 16.

Es ist ein neuartiges alphanumerisches Tastenfeld gezeigt und beschrieben worden, das alle Aufgaben, die zuvor genannt wurden, erfüllt und die ebenfalls genannten Vorteile mit sich bringt. Es können zahlreiche Änderungen, Modifikationen und Variationen und andere Verwendungen und Anwendungsfälle des Erfindungsgegenstandes nach Kenntnis der Beschreibung und der Figuren, die bevorzugte Ausführungsbeispiele betreffen, durch den Fachmann in Betracht gezogen werden. Alle solche Änderungen, Modifikationen und Variationen sowie alle solche Verwendungszwecke und Anwendungszwecke fallen jedoch unter den allgemeinen Erfindungsgedanken und den Schutzumfang für die vorliegende Erfindung, der durch die Ansprüche bestimmt ist.

Patentansprüche

1. Alphanumerisches Tastenfeld, g e k e n n z e i c h -
n e t durch

   (a) eine Basis, die eine nichtleitende, nach obenweisende
       Stützfläche (24) hat;

   (b) zumindest einen leitenden Streifen (26), der auf der
       Stützfläche (24) angeordnet ist, wobei der leitende
       Streifen (26) eine Vielzahl von nach oben weisenden
       Kontaktflächen längs dessen Längsausdehnung und einen
       elektrischen Widerstand zwischen aufeinanderfolgenden
       benachbarten Kontaktflächen aufweist;

   (c) eine flexible Lage (56), die oberhalb des leitenden
       Streifens (26) angeordnet ist und eine leitende Fläche,
       die nach unten auf den leitenden Streifen (26) weist,
       hat, wobei die flexible Lage (56) derart befestigt ist,
       daß sie normalerweise außer Kontakt mit dem leitenden
       Streifen (26) ist, jedoch in Richtung auf den leitenden Streifen (26) an individuellen Punkten oberhalb
       der Kontaktflächen niedergedrückt werden kann, um dadurch einen Kontakt zwischen der leitenden Oberfläche
       und den Kontaktflächen zu bewirken;

   (d) Mittel, die eine elektrische Verbindung zu zumindest
       einem Ende des leitenden Streifens (26) herstellen;

   (e) Mittel, die eine elektrische Verbindung zu der leitenden Oberfläche der flexiblen Lage (56) herstellen.

2. Tastenfeld nach Anspruch 1, dadurch g e k e n n -
z e i c h n e t , daß der leitende Streifen aus einem
länglichen Streifen eines mit einem elektrischen Widerstand
behafteten Materials besteht, das einen im wesentlichen
gleichförmigen, konstanten Widerstand je Längeneinheit hat,
und daß die Kontaktflächen durch das widerstandsbehaftete
Material gebildet sind.

3. Tastenfeld nach Anspruch 1, dadurch g e k e n n - z e i c h n e t , daß der leitende Streifen aus einer Vielzahl von leitenden Kontaktplatten (60) und einer Vielzahl von diskreten Widerständen (58) besteht und daß die Kontaktplatten (60) in Reihe geschaltet sind, wobei jede Kontaktplatte (60) zwischen zwei aufeinanderfolgenden Widerständen (58) angeordnet ist und jeweils eine der Kontaktflächen bildet.

4. Tastenfeld nach Anspruch 1, dadurch g e k e n n - z e i c h n e t , daß die flexible Lage (56) aus aluminiumbeschichtetem Mylar besteht.

5. Tastenfeld nach Anspruch 1, dadurch g e k e n n - z e i c h n e t , daß die flexible Lage (56) mit einem kleinen Abstand von dem leitenden Streifen mittels eines elastischen Materials gehalten wird, das bei den Kontaktflächen angeordnet ist und zwischen die flexible Lage (56) und die Stützfläche (24) eingebettet ist.

6. Tastenfeld nach Anspruch 1, dadurch g e k e n n - z e i c h n e t , daß eine Spannungsquelle ($V_{CC}$) vorgesehen ist, die mit dem ersten oder dem zweiten elektrischen Verbindungsmittel zum Ermöglichen eines Stromflusses durch den leitenden Streifen (26) zu dem jeweils anderen des ersten oder zweiten elektrischen Verbindungsmittels verbunden ist.

7. Tastenfeld nach Anspruch 6, dadurch g e k e n n - z e i c h n e t , daß ein Analog/Digital-Wandler (34) vorgesehen ist, der mit dem anderen der elektrischen Verbindungsmittel zum Umsetzen der Spannung, die über dem anderen elektrischen Verbindungsmittel auftritt, in ein digitales Ausgangssignal verbunden ist.

8. Tastenfeld nach Anspruch 7, dadurch  g e k e n n  -
z e i c h n e t  , daß ein Speicher (38) vorgesehen ist,
der mit dem Analog/Digital-Wandler (34) zum Umsetzen des
digitalen Ausgangssignals aus dem Analog/Digital-Wandler (34)
in einen herkömmlichen digitalen Code, der ein alphanumerisches Zeichen repräsentiert, verbunden ist.

0136630

FIG. 1

FIG. 2

FIG. 3

FIG. 4

2/2

0136630

Vcc

26
0
1
2
3
4
5
6

30

16

32

A/D
34

BINÄRCODE
36

ROM
38

40
ASCII

FIG. 5

Vcc

44
46
48
50
52

54
56

MEHR-
KANAL-
A/D
42

ROM
38

FIG. 6

58
60
58
60

FIG. 7